# EUROPEAN PATENT APPLICATION

(11) **EP 2 629 321 A1**
(43) Date of publication of application: **21.08.2013**
(21) Application number: 12290054.1
(22) Date of filing: 14.02.2012
(51) Int. Cl.: H01L 21/268, H01L 21/322

(54) **Method for forming a gettering layer**

(71) Applicant: Excico France, 92230 Gennevilliers (FR)
(72) Inventor: Huet, Karim, 92230 Gennevilliers (FR)
(74) Representative: BiiP cvba

(57) **Abstract**

The present invention is directed to a method for forming a gettering layer in a semiconductor substrate comprising:
a. exposing a semiconductor substrate to an impurity containing ambient atmosphere,
b. subsequently heating a surface of the semiconductor substrate at a temperature above melting temperature by means of laser irradiation.

## Description

### FIELD OF THE INVENTION

The present invention relates to a method for forming an impurity gettering layer in a semiconductor substrate.

### BACKGROUND OF THE INVENTION

In semiconductor device fabrication, it very important to have the semiconductor substrate surface and near-surface as free as possible from impurities such as metallic contaminants, and from structural defects to achieve sufficient yield and sufficient performance of devices and integrated circuits built into the (near-)surface of the semiconductor substrate.

To realize this, the semiconductor substrates, after building the devices in its top layer, are subjected to a so-called gettering process forcing the impurities to move away from the top surface into the bulk of the substrate and being trapped in so-called gettering sites. In practice, gettering processes are divided into two categories of intrinsic (internal) and extrinsic (external) gettering processes.

Intrinsic gettering refers to gettering that involves impurity trapping sites created by precipitating supersaturated oxygen out of the silicon wafer. The precipitation of supersaturated oxygen creates clusters introducing stress to the wafer that upon relieving by thermal treatment results in dislocations or stacking faults serving as trapping sites for impurities rapidly diffusing towards it.

Extrinsic gettering involves purposely created disorder in the bulk lattice at the back surface of the wafer by external means, followed by a subsequent thermal treatment to relieve the stress in the bulk lattice resulting in formation of a gettering sites and in rapid diffusion of impurities towards these gettering sites.

A disorder of the lattice at the backside of the semiconductor substrate can be achieved in several ways for example by damaging of the back surface by backgrinding, ion implantation, or exposure to high energy laser beam, or deposition of a highly disordered poly-silicon on the back surface of the wafer.

Since in semiconductor device fabrication wafer thinning is required to allow for stacking and high density packaging of integrated circuits (also called dies), and since backgrinding is commonly used for wafer thinning, backgrinding is often simultaneously used for inducing damage in the extrinsic gettering process.

The main drawback of inducing gettering by mechanical damage, in particular by backgrinding, is its tendency to initiate and propagate wafer backside microcracks that may compromise the mechanical strength of the wafer, and its tendency to compromise the required warpage level of the wafer, and consequently also the yield of the dicing step.

Further, another main drawback of conventional extrinsic gettering is the minor quality of the obtained gettering layer due to the use of a polishing step for stress relief at the backside of the wafer after the grinding step.

Therefore other solutions with other or additional process have been suggested in the state of the art. For example US5223734 describes a process of thinning by chemical mechanical polishing, followed by depositing and diffusing a gettering agent into the backside of the wafer and annealing the wafer for driving the gettering agent into the wafer. A disadvantage of this method is the plurality of steps needed to come to a satisfying gettering layer.

Another example is US4782029 wherein excimer short-pulse laser scanning and subsequent anneal to stabilize the gettering sites is suggested. Also in this method an additional high temperature annealing step is needed to achieve a satisfying gettering layer.

Another example is US7666761, proposing grinding followed by non-melt laser scanning or by plasma treatment. A disadvantage of this method is insufficient stress relief.

Considering the drawbacks of known methods, it is an object of the present invention to provide a method for forming a gettering layer wherein inducing damage (mechanical or by implantation) is not necessary to achieve an efficient gettering layer, consequently reducing problems related to microcracks or warpage.

Another object of the present invention is to provide a method for forming a gettering layer wherein the sequence of process steps required is decreased or even minimalized, resulting in a simplified IC manufacturing and reduced manufacturing time.

Another object of the present invention is to provide a method for forming a gettering layer wherein the thermal budget the devices on the semiconductor substrate are exposed to is accurately controlled.

Another object of the present invention is to provide a method for forming a gettering layer in a semiconductor substrate providing besides an efficient gettering layer also sufficient stress relief of the semiconductor substrate, in particular of a thinned semiconductor substrate.

Another object of the present invention is to provide a method for forming a gettering layer obtaining besides an efficient gettering layer also sufficient surface quality enhancement of the semiconductor substrate surface, in particular of a thinned semiconductor substrate.

Further, it is an object of the present invention to provide a method for forming a gettering layer allowing improvement of the mechanical strength of the dies and to reduce die warpage.

An additional object of a method according to the present invention is to reduce semiconductor substrate roughness while providing a gettering layer.

The present invention meets the above objects by exposing a semiconductor substrate to an impurity containing ambient atmosphere, and subsequently heating a surface of the semiconductor substrate at a temperature above melting temperature by means of laser irradiation.

### SUMMARY OF THE INVENTION

The present invention is directed to a method for forming a gettering layer in a semiconductor substrate comprising:
a. exposing a semiconductor substrate to an impurity containing ambient atmosphere,
b. subsequently heating a surface of the semiconductor substrate at a temperature above melting temperature by means of laser irradiation.

### DESCRIPTION OF THE INVENTION

In a first embodiment according to the present invention, a method for forming a gettering layer in a semiconductor substrate is provided comprising:
a. exposing a semiconductor substrate to an impurity containing ambient atmosphere,
b. subsequently heating a surface of the semiconductor substrate at a temperature above melting temperature by means of laser irradiation.

By exposing the semiconductor substrate to an impurity containing ambient and subsequently or simultaneously heating the surface of the semiconductor substrate above its melting temperature, the impurity will be incorporated in the surface.

Without being bound by any theory, the laser irradiation step will thus provide incorporation of the impurity from the ambient, will relieve stress induced by this incorporation, and will induce diffusion of impurities already present in the semiconductor substrate before formation of the gettering layer towards the remaining dislocations or stacking faults.

A first advantage of this method is that, due to incorporation of an impurity, inducing damage (mechanical of by implantation) may not be necessary to achieve an efficient gettering layer, consequently reducing problems related to microcracks or warpage.

Another advantage is obviously that, because only heating in an impurity containing ambient atmosphere is required, the sequence of process steps needed may be decreased or even minimalized, resulting in a simplified IC manufacturing and reduced manufacturing time.

A general advantage is that this method may allow better gettering efficiency, leading to lower leakage and better device performance (e.g. data retention in the case of memory devices).

Since laser irradiation offers significant advantages over a conventional heating process by enabling very fast heat treatment, if needed at high temperature, and shallow depth of the heated region, it is a very suitable technique for heating a surface of the semiconductor substrate limited to a few micrometers deep to temperatures sufficiently high for melting and recrystallizing the surface while avoiding that other regions of the same substrate reach temperatures exceeding 250°C. Compared to using furnace anneal, using laser irradiation makes the thermal budget the devices on the semiconductor substrate are exposed to accurately controllable.

The impurity containing ambient atmosphere may be the ambient atmosphere in a closed cavity, e.g. the atmosphere within a process chamber of a manufacturing tool, or an open ambient atmosphere, e.g. the atmosphere of a cleanroom.

The impurity present in the ambient atmosphere may be any impurity that is suitable for inducing formation of a gettering layer and that can be inherently present in or brought into an artificial or a natural ambient atmosphere. Such impurity may be for example oxygen, argon, carbon, nitrogen, boron, phosphorus, arsenic, antimony, fluorine or any derivative thereof.

In a preferred embodiment, the ambient atmosphere may be ambient air and the impurity may be oxygen. Without being bound to any theory, water present in the atmosphere in the form of humidity will induce some monolayers of water at the surface of a highly hydrophilic silicon substrate. This water may be an oxygen source to be incorporated during the laser irradiation.

In an embodiment of the present invention, the heating temperature to which the surface of the semiconductor substrate may be exposed may be above 900°C, for example in case of a germanium semiconductor substrate, above 1000°C, above 1200°C, or even above 1400°C, for example in case of a silicon semiconductor substrate.

In embodiment of the present invention, the semiconductor substrate may be grinded, polished or (dry or wet) etched prior to laser irradiation, usually for the purpose of thinning. It is understood that the impurity containing ambient atmosphere may be created during grinding, polishing or etching, or even by grinding, polishing or etching itself.

Since in state-of-the-art device manufacturing, semiconductor substrates are often thinned before dicing and packaging, the advantage of a method in accordance with the present invention is that by heating the thinned surface above melting temperature, it may provide also sufficient stress relief and sufficient surface quality enhancement, e.g. reducing roughness or haze, of the semiconductor substrate surface.

In the context of the present invention, the laser source may be any laser source whose wavelength, energy and pulse duration is adapted to a method in accordance with the present invention, such as solid state lasers, or excimer lasers. Preferably, the laser source may be an excimer layer, more preferably a xenon chloride excimer laser.

The wavelength of the laser source may be in the range of 100 nm to 900 nm, 190 nm to 600 nm, 190 nm to 550 nm, or 190 nm to 480 nm due to the high energy absorption of semiconductor materials such as silicon, germanium or silicon carbide at those wavelengths.

The irradiation energy may be in the range of 1 Joules to 25 Joules. In order to achieve these energies, the laser discharge volume is optimized to typically 10 cm (inter electrodes spacing) x 7 to 10 cm (discharge width) x 100 to 200 cm (discharge length).

In an embodiment of the present invention, the laser source may be adapted to produce a irradiation beam with an energy density between 0,1 and 10 J/cm², preferably between 1 and 10 J/cm², most preferably between 1 to 5 Joules/cm². The laser energy density may be adapted to match the desired temperature gradient in the depth direction of the semiconductor substrate in order to achieve the required melt depth and/or the required thickness of the melting and recrystallizing layer.

In a preferred embodiment, the laser may be an excimer laser adapted to produce a large area output beam of more than 60 cm², more than 80 cm², preferably 100 cm², having a projected beam spot typically of at least 1 cm², at least 5 cm², and up to 10 cm² with an energy density between 0,1 and 10 J/cm².

In a particular embodiment in accordance with the present invention, with each pulse a portion of at least 1 cm², at least 5 cm² , at least 8 cm², or at least 10 cm² may be irradiated, which makes the present invention suitable for industrial manufacturing semiconductor devices.

The irradiation beam may be continuous or pulsed, preferably pulsed, and having a pulse duration in the range from 20 ns to 1000 ns, or between 100 ns and 300 ns, or preferably between 100 and 200 nanoseconds.

In a preferred embodiment, the heating step has a suitable duration for at least partially relieve grinding, polishing, or etching stress and simultaneously form stable dislocations and/or stacking fault in the gettering layer.

Additionally, by accurately controlling the laser irradiation density and the pulse length, the melting and recrystallization of the substrate surface may be performed at a sufficiently low velocity to ensure at least partial stress relief, but at sufficiently high velocity to drive impurities already present in the semiconductor substrate before formation of the gettering layer towards the remaining dislocations or stacking faults.

In the context of the present invention, the semiconductor substrate may be any semiconductor material (bulk or thin film) suitable for semiconductor device manufacturing such as for example mono crystalline silicon, undoped silicon or doped silicon, polycrystalline silicon, implanted silicon, silicon carbide, amorphous silicon, silicon germanium, or silicon on insulator (SOI).

Any method in accordance with the present invention may be used in the manufacturing of any of kind of microelectronic device subject to stress and metal contamination, in particular involving thinned substrates, such as for example memory devices, System-in-package devices (SiP), System-on-Chip devices (SoC), Package-on-Package devices (PoP) and Package-in-Package devices (PiP).

Since the density of gettering sites in the bulk of a semiconductor substrate decreases proportional to the thickness of the substrate, the efficiency of intrinsic gettering decreased also. Moreover, the gettering sites need to be away from the device layer (at least a few µm, 10µm in the general case), so for very thin substrates, intrinsic gettering cannot be used and extrinsic gettering is mandatory. In both cases, a method according to the present invention will provide a number of advantages as described already above.

A method in accordance with the present invention may be also used for forming a local gettering layer since with laser irradiation localized treatment is a possibility.

### EXAMPLE:

Starting material is a conventional silicon device wafer at completion of a memory device front-side manufacturing process. The back-side manufacturing process then proceeds as follows:
- Deposition of a frontside protection tape (BG tape)
- Wafer back-grinding (thinning)
- Surface polishing for (at least partial) stress relief, and for wafer thickness control via removal of the surface layer
- Backside melting and recrystallization by laser in ambient atmosphere
- Dicing die attach film lamination and frame mounting
- BG tape removal
- Chip dicing with saw blade or laser
- Die bonding
- Wire bonding
- Standard back end steps (molding, marking, solder ball placement, singulation)

In this example, the surface layer after back-grinding is removed completely by polishing, such that after polishing substantially no damage is present anymore in the surface layer. However, by subsequently laser annealing the surface of the device wafer in ambient atmosphere at a temperature above melting temperature a gettering layer is created.

## Claims

1. A method for forming a gettering layer in a semiconductor substrate comprising:
a. exposing a semiconductor substrate to an impurity containing ambient atmosphere,
b. subsequently heating a surface of the semiconductor substrate at a temperature above melting temperature by means of laser irradiation.

2. A method according to claim 1, wherein the impurity is oxygen.

3. A method according to claim 1 or claim 2, wherein the impurity containing ambient atmosphere is ambient air.

4. A method according to claim 1 to 3, wherein the laser irradiation is generated by an excimer laser.

5. A method according to claim 1 to 4, wherein the laser irradiation is generated by a pulsed laser.

6. A method according to claim 5, wherein the laser irradiation consist of one pulse with duration between 20 nanoseconds and 1 microsecond.

7. A method according to claim 1 to 6, wherein the heating temperature is at least 1000°C.

8. A method according to claim 7, wherein the heating temperature is at least 1400°C.

9. A method according to claim 1 to 8, wherein additionally the semiconductor
substrate is grinded or polished.

10. A method according to claim 9, wherein the heating has a suitable duration for
at least partially relieve grinding, polishing, or etching stress, and
simultaneously form stable dislocations and/or stacking faults in the gettering layer.
